# EUROPÄISCHE PATENTANMELDUNG

(11) **EP 4 044 079 A1**
(43) Veröffentlichungstag der Anmeldung: **17.08.2022**
(21) Anmeldenummer: 21157084.1
(22) Anmeldetag: 15.02.2021
(51) Int. Cl.: G06Q 10/04

(54) **SYSTEM ZUR RAUM- UND/ODER FLÄCHENPLANUNG, VERWENDUNG EINES GENETISCHEN ALGORITHMUS**

(71) Anmelder: Siemens Aktiengesellschaft, 80333 München (DE)
(72) Erfinder: Johnson, Rebecca, 81739 München (DE)

(57) **Zusammenfassung**

Die Erfindung betrifft ein System zur Raum- und/oder Flächenplanung, insbesondere ein automatisiertes und rechnergestütztes System. Außerdem betrifft die Erfindung die Verwendung eines genetischen Algorithmus. Durch die Erfindung wird erstmals eine Möglichkeit offenbart, wie langwierige Optimierungsprozesse durch künstliche Intelligenz übernommen werden können. Dazu wird vorgeschlagen, dass erste Daten eine Fläche oder einen Raum betreffend, zusammen mit zweiten Daten eine Regelung, wie die Fläche und/oder der Raum zu bestücken ist, betreffend, mit dritten Daten, Objekte und objektbezogene Regeln betreffend einem genetischen Algorithmus zur Verfügung gestellt werden, der durch ein iteratives Verfahren die Verteilung der Objekte in dem Raum und/oder auf der Fläche optimiert und die optimierten Lösungen dem Nutzer präsentiert.

## Beschreibung

Die Erfindung betrifft ein System zur Raum- und/oder Flächenplanung, insbesondere ein automatisiertes und rechnergestütztes System. Außerdem betrifft die Erfindung die Verwendung eines genetischen Algorithmus.

Der umbaute Raum generell und insbesondere der mit guter Infrastruktur, in Großstädten und/oder auf Fabrikgeländen ist teuer und sollte optimal genutzt werden. Ebenso verhält es sich bei Nutzflächen, hier ist auch eine optimierte Nutzung der zur Verfügung stehenden Flächen Gegenstand detaillierter Planung. Beispielsweise die Bestückung einer Leiterplatte respektive einer Platine erfolgt auch nach vorheriger Planung unter Einbeziehung der vorhandenen Anschlüsse etc.

Bei der Bestückung einer Fläche, beispielsweise einer Platine und/oder Möblierung eines Innenraumes, sei es für ein Wohngebäude, ein Bürogebäude, eine Lagerhalle, ein Theater, eine Fabrikationsstraße, ein Fabrikationsgelände und/oder für einen sonstigen Innenraum treten immer wieder ähnliche Fragestellungen auf. In der Regel werden verschiedene Fachleute in die Raumplanung einbezogen, die alle verschiedene Gesichtspunkte der Raumnutzung/Raumgestaltung in die Planung einbringen.

Beispielsweise gibt es Innenarchitekten, die die ästhetischen Gesichtspunkte in die Planung einbringen. Dann gibt es Techniker, die im Falle von Fabrikplanung, die Stellung der einzelnen Maschinen zueinander unter dem Gesichtspunkt des Prozessablaufs betrachten. Des Weiteren werden Anforderungen an den Standort der Maschinen, Schreibtische, Labortische etc. gestellt hinsichtlich ihrer Lage zu den Versorgungsleitungen, Heizungen, Fenster, Raumbelüftung etc. gestellt. Schließlich gibt es noch den Platzbedarf der einzelnen Objekte, wie Maschinen, Tische, Stühle, die in dem Raum unterzubringen sind, sowie die Einzelanforderungen, beispielsweise Kühlaggregate nicht zu nah an die Heizung und nicht ins pralle Sonnenlicht... etc. Alle diese Gesichtspunkte werden in stundenlangen Treffen besprochen und diskutiert, bis schließlich eine Lösung, die alle Aspekte zufriedenstellend berücksichtigt, entworfen und umgesetzt wird.

Insbesondere während einer Pandemie können die Randbedingungen sich auch schlagartig ändern und es besteht der Bedarf, kurzfristig Lösungen für die Raumplanung und Verteilung der Objekte unter geänderten Bedingungen bereitzustellen.

Daher stellt sich die Aufgabe, wie diese Randbedingungen zur Raum- Flächenplanung automatisiert erfasst und automatisiert Lösungen zur Raum- respektive Flächenplanung erstellt werden können.

Diese Aufgabe wird durch den Gegenstand der vorliegenden Erfindung, wie er in der Beschreibung und den Ansprüchen offenbart ist, gelöst.

Dementsprechend ist Lösung der vorliegenden Aufgabe und Gegenstand der vorliegenden Erfindung die Verwendung eines genetischen Algorithmus zur Optimierung der Verteilung einer Anzahl vorgegebener Objekte nach auswählbaren Parametern, wobei die Objekte gemäß objektbezogener Regeln auf einer Fläche und/oder in einem vorgegebenem Raum anzuordnen sind, derart, dass automatisiert und rechnergestützt Lösungen präsentiert werden.

Außerdem ist Gegenstand der Erfindung ein System zur automatisierten Verteilung einer Anzahl vorgegebener Objekte in einem Raum und/oder auf einer Fläche, Folgendes umfassend:
- ein oder mehrere Module zur Eingabe und/oder Generierung von Daten erster, zweiter und dritter Art,
   o wobei Daten erster Art den Raum und/oder die Fläche betreffen,
   ∘ wobei Daten zweiter Art die Parameter, Muster, Regeln, Regularien betreffen,
   ∘ wobei Daten dritter Art die Objekte betreffen, sowie
- ein oder mehrere Module zur Ausgabe und/oder Präsentation von Lösungen,
- ein oder mehrere Schnittstelle(n) zur Übermittlung der Daten erster, zweiter und dritter Art an zumindest eine mit einem Prozessor verbundene Speichereinheit, wobei der zumindest eine Prozessor zur Durchführung eines genetischen Algorithmus konfiguriert ist,
dadurch gekennzeichnet, dass
- der genetische Algorithmus die Daten erster, zweiter und dritter Art aus der Speichereinheit abruft, rechnergestützt verarbeitet und automatisiert zunächst eine Generation an Lösungen bereitstellt, wobei die Lösungen der ersten und der folgenden Generation hinsichtlich ihrer Fortschrittlichkeit bezüglich vorgegebener Parameter evaluiert und selektiert werden, dann
- nach erfolgter Selektion die selektierten Lösungen rekombiniert und den Vorgang wiederholend der genetische Algorithmus eine Schleife durchläuft, in der die berechneten Lösungen immer wieder bezüglich ihrer Fortschrittlichkeit evaluiert, selektiert und rekombiniert werden, wobei
- zumindest eine Schnittstelle vorgesehen ist, über die die fortschrittlichsten Lösungen einer Generation an eine künstliche Intelligenz und/oder an ein neuronales Netzwerk übermittelbar sind,
- wobei die künstliche Intelligenz und/oder das neuronale Netzwerk die fortschrittlichsten Lösungen zur Erzeugung neuer Regeln zur Verteilung einer Anzahl vorgegebener Objekte in einem Raum und/oder auf einer Fläche nutzt, die dann an den Prozessor zur Weiterentwicklung des genetischen Algorithmus übermittelt werden, und
- zumindest eine Schnittstelle vorgesehen ist, durch die eine Anzahl von auf den oder die vorgegebenen Parameter hin optimierte Lösungen an die Module zur Ausgabe und/oder Präsentation der Lösungen übermittelbar ist.

Allgemeine Erkenntnis der Erfindung ist es, dass ein System alle Daten, die zur Berechnung geeigneter Flächen- und/oder Raumbestückung erforderlich sind, speichern und verarbeiten kann, so dass durch einen oder mehrere entsprechend konfigurierte(n) Prozessor(en) das Ausführen eines genetischen Algorithmus nach der Initiierung Lösungen durch Evaluation, Selektion und Rekombination als Grundlage für die Erzeugung weiterer Lösungen zur Flächen- und/oder Raumplanung automatisiert, z. B. über eine künstliche Intelligenz, nutzbar sind.

Dazu umfasst das System insbesondere einen oder mehrere Prozessor(en), der so konfiguriert ist, dass er geeignet ist, um einen genetischen Algorithmus auszuführen.

Dazu umfasst das System eine oder mehrere Speichereinheit(en) mit jeweiligen Schnittstellen zu dem einen oder mehreren Prozessoren, in denen Daten zum Raum und/oder zur Fläche, Daten zu den Objekten sowie objektbezogenen Regeln, Parameter und Vorgaben zur Optimierung, sowie zur Rekombination als geeignet identifizierte Lösungen, die in einem iterativen Verfahren jeweils die Grundlage der Berechnung weiterer Lösungen darstellen, speicherbar und abrufbar sind.

Zudem umfasst das System Module, die geeignet sind, Daten zu erfassen und/oder zu erzeugen und zumindest einer der Speichereinheiten des Systems zu Verfügung zu stellen, von denen der Prozessor die Daten abruft.

So umfasst das System eine oder mehrere Speichereinheit(en), in der oder in denen Daten, insbesondere
- Zumindest eine Anzahl von Daten erster Art, den zu bestückenden Raum und/oder die zu bestückende Fläche betreffend,
- Zumindest eine Anzahl von Daten zweiter Art, Parameter wie beispielsweise die zu beachtenden Verteilungs- und/oder Anordnungs-Regeln, -Regularien und/oder -Muster betreffend, und
- Zumindest eine Anzahl von Daten dritter Art, die zu verteilenden Objekte sowie deren objektbezogene Regeln und/oder -Regularien betreffend,
für den oder die Prozessor(en) des Systems zur Verarbeitung bereitgestellt sind.

Im Betrieb ruft der Prozessor die Daten, die über die Module in eine Speichereinheit des Systems gelangt sind, über eine geeignete Schnittstelle ab.

Dann startet der Prozessor mit diesen Eingaben das iterative Verfahren, in dem er unter Einbeziehung aller gegebenen Daten erster, zweiter und dritter Art, unter Berücksichtigung der Regeln und Randbedingungen Lösungen berechnet und präsentiert, wie die Verteilung der Objekte in dem gegebenen Raum und/oder auf der gegebenen Fläche unter den vorgegebenen Regeln aussehen könnte. Dabei bedient sich das iterative Verfahren einer vergleichenden Fortschrittskontrolle, also einer Evaluation, bei der geprüft wird, welche der Lösungen hinsichtlich vorgegebener Parameter, z.B. Raumnutzung, Distanz zwischen den Tischen, Flexibilität, Vertraulichkeit, Wohlbefinden, Feng-Shui-Konformität etc. anderen Lösungen überlegen sind. Diese Lösungen werden dann einem Nutzer ausgewählt und durch den genetischen Algorithmus rekombiniert. Aus diesen Rekombinationen werden wiederum neue Generationen an Lösungen erzeugt, die dann ebenfalls wieder evaluiert, selektiert und dann wieder rekombiniert werden. Diese Schleifen werden durch den genetischen Algorithmus fortgeführt, bis er abgebrochen wird. Die Präsentation der Lösungen erfolgt bevorzugt in Realtime, also jede Generation an Lösungen wird an die Module zur Ausgabe der Lösungen und/oder zur Präsentation der Lösungen übermittelt. So werden Nutzer in die Selektion optional einbezogen, deren Selektion zum Training der künstlichen Intelligenz nutzbar ist.

Zur Weiterentwicklung des genetischen Algorithmus werden die selektierten Lösungen einem neuronalen Netzwerk und/oder einer künstlichen Intelligenz - KI - des Systems - wieder über entsprechende Schnittstellen des Systems - übermittelt. Die KI und/oder ein Nutzer kann daraus händisch oder automatisiert die Lösungen auswählen, die er für das weitere iterative Verfahren als Grundlage zur Rekombination nutzen will. Die künstliche Intelligenz und/oder das neuronale Netzwerk kann daraus weitere Regeln für das iterative Verfahren entwickeln und diese neuen Regeln als Daten "zweiter Art" abspeichern respektive dem Prozessor übermitteln.

Die Iterationsstufen werden zeitgleich über Ausgabegeräte präsentiert, wobei der Nutzer beispielsweise die Parameter, nach denen zu optimieren ist, ändern kann. Wenn die präsentierten Lösungen hinsichtlich z.B. der Raumnutzung eines Büros durch Verteilen von Schreibtischen bereits optimal sind, kann der Nutzer so im laufenden Verfahren der Iterationsschleife nach Realisierung eines bestimmten Winkels zwischen Schreibtisch und Fenster hin optimieren lassen. Diese Regelung kann auch stufenlos erfolgen, so dass man den einen Regler runterfährt und den anderen in der gleichen Zeit hoch.

Nach einer vorgegebenen Anzahl von Iterationsstufen wird der genetische Algorithmus abgebrochen und das System präsentiert über die Module zur Ausgabe der Lösungen eine oder mehrere optimale Lösungen, die dann einem entsprechenden Anzeige- und/oder Wiedergabegerät übermittelt werden und durch dieses darstellbar sind. Beispielsweise kann man die Lösungen auf einem Anzeigegerät wie einem Monitor anschauen und/oder als Ausdruck erhalten. Dazu umfasst das System einen Drucker respektive ein Anzeigegerät.

Das System umfasst ein oder mehrere Module, durch die Daten der "ersten Art" bezüglich des Raumes und/oder der Fläche erfasst und/oder erzeugt werden. Beispielsweise umfasst das System zur Bereitstellung der Daten erster Art hinsichtlich des Raumes als Punktewolke(n), insbesondere als 3D-Punktewolke(n) eine 3D-Kamera. Dabei können insbesondere auch spezielle Raumgegebenheiten, wie sie beispielsweise bei Altbauten bestehen, erfasst werden. Hervorragend geeignet sind auch Laserscan-Verfahren und Vorrichtungen zur Erfassung und/oder Erzeugung der Daten erster Art. Bezogen auf die Bestückung einer Fläche, wie beispielsweise einer Platine mit elektronischen Bauteilen, können diese Daten die Oberflächenbeschaffenheit, das Ausmaß, die vorgegebenen Leiterbahnen etc. betreffen.

"Platine" steht dabei für eine Leiterplatte, ein Trägerelement für elektronische Bauteile wie Transistoren, Widerstände, Kondensatoren, Chips etc. angeordnet sind.

Die Daten erster Art definieren die Gegebenheiten des Raumes und/oder der Fläche. Diese können manuell eingegeben werden und/oder rechnergestützt oder automatisiert mittels Modulen wie Kamera und/oder Laserscanner erzeugt, gespeichert und übermittelt werden.

Als "zweite Daten" werden die Parameter, Vorgaben, Randbedingungen, Regularien, Muster und/oder Regeln bezeichnet, die das Zusammenspiel der Objekte in dem Raum und/oder auf der Fläche auszeichnen. Dazu gehört/gehören auch der/die Parameter, auf den/die hin die Beurteilung der Fortschrittlichkeit der gefundenen Lösung und schließlich die Optimierung durch den genetischen Algorithmus erfolgt.

In der Regel wird die Optimierung der rechnergestützt gefundenen Lösungen zur Verteilung einer Anzahl vorgegebener Objekte in einem Raum/auf einer Fläche nicht nur nach einem vorgegebenen Parameter, sondern nach mehreren Parametern gleichzeitig erfolgen. Dabei ist es wahrscheinlich, dass nicht alle Parameter gleiche Wichtigkeit haben, so dass die Gewichtung der Parameter unterschiedlich sein wird. Da es sich bei dem Verfahren, das durch ein System gemäß der Erfindung ausgeführt wird um ein iteratives Verfahren handelt, kommen immer wieder neue Lösungen ins Spiel und es ist deshalb möglich, die Gewichtung der Parameter oder überhaupt die Parameter während des Verfahrens zu ändern.

Beispiele für Parameter z.B. bei der Raumplanung eines Büros sind: Vorgaben betreffend Schreibtische pro Flächeneinheit, Schrankfläche pro Mitarbeiter, alle 5 m ein Feuerlöscher, Vermeidung von Gruppen aus mehr als 9 Schreibtischen, Entfernung des Stuhls zum Fenster, Bilder an der Wand, Feng-Shui-Regeln etc... Je genauer und vollständiger diese Daten, die Parameter repräsentierend, zweiter Art dem System durch manuelle oder automatisierte Eingabe zur Verfügung gestellt werden, desto größere Wirkung der automatisierten Optimierungsschritte auf die gefundenen Lösungen.

Die Daten der "dritten Art" sind Daten die zu verteilenden Objekte betreffend. Bei dem oben erwähnten Beispiel der Büroraum-Bestückung sind das Tische, Schreibtische, Schreibtischstühle, Papierkörbe, Ablagen, etc., die in dem Büro zu verteilen sind. Dabei kann die Erfassung und Erzeugung dieser Objektdaten der dritten Art beispielsweise auch wieder manuell eingegeben werden, über entsprechende Produktdatenblätter automatisiert übermittelt und/oder mittels Laserscan oder 3d-Kamera erfolgen. Zu diesen Daten dritter Art gehören auch die zu dem jeweiligen Objekt gehörenden Regeln. Diese sind zu berücksichtigende objekt-bezogene Vorgaben, wie
- vor jeden Schreibtisch passt ein Stuhl,
- jeder Monitor auf dem Schreibtisch braucht einen Anschluss,
- der Schreibtisch steht in einem speziellen Winkel zum Fenster, zur Wand etc.

Der genetische Algorithmus präsentiert Lösungen, in denen die Verteilung der Objekte den objektbezogenen Regeln entspricht, wobei rechnergestützt Vorgaben gemacht werden können, ob Regeln unabdingbar - wie der Stuhl vor dem Schreibtisch oder nur vorteilhaft - wie die Befolgung der Feng-Shui-Regeln - sind.

Das System kann auch eine Schnittstelle zu einem Computer-Aided-Design "CAD"-System, insbesondere wenn die Räume, die Fläche nicht fix definiert ist, sondern abänderbar ist, umfassen.

Unter einem genetischen Algorithmus wird ein rechnergestütztes iteratives Verfahren verstanden, das durch Berechnung Lösungen präsentiert, bei denen grundsätzlich keine Verbesserung zu bestehenden Lösungen garantiert ist, die jedoch durch Mutation und Rekombination einen Suchraum eröffnen, in dem durch Selektion, die manuell oder mittels einer künstlichen Intelligenz erfolgen kann, eine Richtung vorgegeben wird, die bei erfolgreicher Konzeption zum globalen Optimum führt.

Vorliegend wird mit "Parameter" eine Variable bezeichnet, die einen programmexternen gesetzten Einflussfaktor bezeichnet. Diese betreffen insbesondere bestimmte Grenzwerte und/oder Auswahlbedingungen.

Als "Verteilung einer Anzahl vorgegebener Objekte in einem Raum und/oder auf einer Fläche" und oder als "Lösung" wird vorliegend beispielsweise ein Layout und/oder ein Plan wie und wo welche Objekte auf einer Fläche oder in einem Raum verteilbar sind, bezeichnet.

Unter "künstlicher Intelligenz" wird ein Gerät zum maschinellen Lernen verstanden. Die künstliche Intelligenz empfängt in einem neuronalen Netzwerk Lösungen mit Evaluation, wobei die künstliche Intelligenz durch diese Evaluation trainiert wird und sie schließlich dazu nutzt, daraus neue Regeln abzuleiten, die sie dem genetischen Algorithmus wieder zur Verfügung stellt zur Evaluation und Selektion der nächsten Generation an Lösungen.

Unter einem "Prozessor" kann im Zusammenhang mit der Erfindung beispielsweise eine Maschine, eine künstliche Intelligenz mit neuronalem Netzwerk und/oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungs-spezifische integrierte Schaltung, engl. Application-Specific Integrated Circuit), oder einen DSP (Digitaler Signal-prozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Bevorzugt handelt es sich um einen programmierbaren Prozessor, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens oder der Module, oder anderer Aspekte und/oder Teilaspekte der Erfindung realisiert.

Unter einem "Modul" kann im Zusammenhang mit der Erfindung beispielsweise ein Laserscanner, eine 3D-Kamera, ein Prozessor und/oder eine Speichereinheit zum Speichern von Programmcode verstanden werden. Beispielsweise ist der Prozessor speziell dazu eingerichtet, den Programmcode derart auszuführen, damit der Prozessor Funktionen ausführt, um das erfindungsgemäße Verfahren oder einen Schritt des erfindungsgemäßen Verfahrens zu implementieren oder realisieren. Die jeweiligen Module können beispielsweise auch als separate bzw. eigenständige Module ausgebildet sein. Hierzu können die entsprechenden Module beispielsweise weitere Elemente umfassen. Diese Elemente sind beispielsweise eine oder mehrere Schnittstellen (z. B. Datenbankschnittstellen, Kommunikationsschnittstellen - z. B. Netzwerkschnittstelle, WLAN-Schnittstelle) und/oder eine Evaluierungseinheit (z. B. ein Prozessor) und/oder eine Speichereinheit. Mittels der Schnittstellen können beispielsweise Daten ausgetauscht (z. B. empfangen, übermittelt, gesendet oder bereitgestellt werden). Mittels der Evaluierungseinheit können Daten beispielsweise rechnergestützt und/oder automatisiert verglichen, überprüft, verarbeitet, zugeordnet oder berechnet werden.

Mittels einer Speichereinheit können im System Daten beispielsweise rechnergestützt und/oder automatisiert gespeichert, abgerufen oder bereitgestellt werden.

Unter "rechnergestützt" oder "computergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt. Beispielsweise ist unter "rechnergestützt" oder "computergestützt" auch "computerimplementiert" zu verstehen.

Unter "Bereitstellen", insbesondere in Bezug auf Daten, Metadaten und/oder sonstige Informationen, kann im Zusammenhang mit der Erfindung beispielsweise ein rechnergestütztes Bereitstellen verstanden werden. Das Bereitstellen erfolgt beispielsweise über eine Schnittstelle (z. B. eine Datenbankschnittstelle, eine Netzwerkschnittstelle, eine Schnittstelle zu einer Speichereinheit). Über diese Schnittstelle können beispielsweise beim Bereitstellen entsprechende Daten und/oder Informationen übermittelt und/oder gesendet und/oder abgerufen und/oder empfangen werden. Unter "Bereitstellen" kann im Zusammenhang mit der Erfindung beispielsweise auch ein Laden oder ein Speichern, beispielsweise einer Transaktion mit entsprechenden Daten verstanden werden. Unter "Bereitstellen" kann beispielsweise auch ein Übertragen (oder ein Senden oder ein Übermitteln) von entsprechenden Daten von einem Knoten zu einem anderen Knoten verstanden werden.

Durch die Erfindung wird erstmals eine Möglichkeit offenbart, wie langwierige Optimierungsprozesse durch künstliche Intelligenz übernommen werden können. Dazu wird vorgeschlagen, dass erste Daten eine Fläche oder einen Raum betreffend, zusammen mit zweiten Daten eine Regelung, wie die Fläche und/oder der Raum zu bestücken ist, betreffend, mit dritten Daten, Objekte und objektbezogene Regeln betreffend einem genetischen Algorithmus zur Verfügung gestellt werden, der durch ein iteratives Verfahren die Verteilung der Objekte in dem Raum und/oder auf der Fläche optimiert und die optimierten Lösungen dem Nutzer präsentiert.

## Patentansprüche

1. System zur automatisierten Verteilung einer Anzahl vorgegebener Objekte in einem Raum und/oder auf einer Fläche, Folgendes umfassend:
ein oder mehrere Module zur Eingabe und/oder Generierung von Daten erster, zweiter und dritter Art,
a. wobei Daten erster Art den Raum und/oder die Fläche betreffen,
b. wobei Daten zweiter Art die Parameter, Muster, Regeln, Regularien betreffen,
c. wobei Daten dritter Art die Objekte betreffen, sowie
ein oder mehrere Module zur Ausgabe und/oder Präsentation von Lösungen,
ein oder mehrere Schnittstelle(n) zur Übermittlung der Daten erster, zweiter und dritter Art an zumindest eine mit einem Prozessor verbundene Speichereinheit, wobei der zumindest eine Prozessor zur Durchführung eines genetischen Algorithmus konfiguriert ist,
**dadurch gekennzeichnet, dass**
der genetische Algorithmus die Daten erster, zweiter und dritter Art aus der Speichereinheit abruft, rechnergestützt verarbeitet und automatisiert zunächst eine Generation an Lösungen bereitstellt, wobei die Lösungen der ersten und der folgenden Generation hinsichtlich ihrer Fortschrittlichkeit bezüglich vorgegebener Parameter evaluiert und selektiert werden, dann
nach erfolgter Selektion die selektierten Lösungen rekombiniert und den Vorgang wiederholend der genetische Algorithmus eine Schleife durchläuft, in der die berechneten Lösungen immer wieder bezüglich ihrer Fortschrittlichkeit evaluiert, selektiert und rekombiniert werden, wobei
zumindest eine Schnittstelle vorgesehen ist, über die die fortschrittlichsten Lösungen einer Generation an eine künstliche Intelligenz und/oder an ein neuronales Netzwerk übermittelbar sind,
wobei die künstliche Intelligenz und/oder das neuronale Netzwerk die fortschrittlichsten Lösungen zur Erzeugung neuer Regeln zur Verteilung einer Anzahl vorgegebener Objekte in einem Raum und/oder auf einer Fläche nutzt, die dann an den Prozessor zur Weiterentwicklung des genetischen Algorithmus übermittelt werden, und
zumindest eine Schnittstelle vorgesehen ist, durch die eine Anzahl von auf den oder die vorgegebenen Parameter hin optimierte Lösungen an die Module zur Ausgabe und/oder Präsentation der Lösungen übermittelbar ist.

2. System nach Anspruch 1, wobei die Fläche, auf der automatisiert die Verteilung einer Anzahl vorgegebener Objekte gelöst wird, eine Platine ist.

3. System nach Anspruch 1, wobei der Raum, in dem automatisiert die Verteilung einer Anzahl vorgegebener Objekte gelöst wird, eine Fabrikhalle ist.

4. System nach Anspruch 1, wobei der Raum, in dem automatisiert die Verteilung einer Anzahl vorgegebener Objekte gelöst wird, ein Büroraum ist.

5. System nach einem der vorhergehenden Ansprüche, wobei Daten erster Art durch ein Modul zur Raumerkennung automatisiert erzeugt werden.

6. System nach Anspruch 5, wobei das Modul ein Laserscanner ist.

7. System nach einem der vorhergehenden Ansprüche, bei dem zumindest eine Schnittstelle zu einem Prozessor, der konfiguriert ist, um Computer Aided Design -CAD- auszuführen, vorgesehen ist.

8. System nach einem der vorhergehenden Ansprüche, bei dem das Präsentieren jeder Generation von Lösungen vorgesehen ist.

9. System nach einem der vorhergehenden Ansprüche, bei dem das Modul zur Präsentation ein Anzeigegerät wie ein Monitor ist.

10. System nach einem der vorhergehenden Ansprüche, bei dem die Optimierung hinsichtlich mehrerer Parameter gleichzeitig erfolgt.

11. System nach Anspruch 10, bei dem die Parameter unterschiedliche Gewichtung haben.

12. Verwendung eines genetischen Algorithmus zur Optimierung der Verteilung einer Anzahl vorgegebener Objekte nach auswählbaren Parametern, wobei die Objekte gemäß objektbezogener Regeln auf einer definierten Fläche und/oder in einem vorgegebenem Raum anzuordnen sind, derart, dass automatisiert und rechnergestützt Lösungen präsentiert werden.

13. Verwendung nach Anspruch 11, wobei der vorgegebene Raum ein Büroraum und/oder eine Fabrikhalle ist.

14. Verwendung nach Anspruch 11, wobei die vorgegebene Fläche eine Platine ist.

15. Verwendung nach einem der Ansprüche 11 bis 14, wobei der genetische Algorithmus rechnergestützt über eine dafür eingerichtete Schnittstelle mittels einer künstlichen Intelligenz und/oder mittels eines neuronalen Netzwerks durchgeführt wird.
